(19) Europäisches Patentamt
European Patent Office
Office européen des brevets

(11) **EP 4 589 310 A1**

(12) **EUROPÄISCHE PATENTANMELDUNG**

(43) Veröffentlichungstag:
23.07.2025 Patentblatt 2025/30

(21) Anmeldenummer: 25152558.0

(22) Anmeldetag: **17.01.2025**

(51) Internationale Patentklassifikation (IPC):
*G01R 27/16* (2006.01)    *G01R 31/34* (2020.01)
*G01R 27/02* (2006.01)    *G01R 31/42* (2006.01)
*H02J 3/26* (2006.01)    *H02K 19/36* (2006.01)

(52) Gemeinsame Patentklassifikation (CPC):
**G01R 27/16; G01R 31/34; G01R 31/343;**
G01R 27/02; G01R 31/42; H02J 3/26

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**
Benannte Erstreckungsstaaten:
**BA**
Benannte Validierungsstaaten:
**GE KH MA MD TN**

(30) Priorität: **17.01.2024 DE 102024101253**

(71) Anmelder: **Caterpillar Energy Solutions GmbH 68167 Mannheim (DE)**

(72) Erfinder: **Aren, Assiet 68167 Mannheim (DE)**

(74) Vertreter: **Nordmeyer, Philipp Werner Maucher Jenkins Patent- und Rechtsanwälte Liebigstraße 39 80538 München (DE)**

(54) **STROMQUALITÄTSMESSUNG EINER NETZGENERATORANLAGE**

(57) Die vorliegende Erfindung betrifft ein Verfahren zum Überprüfen einer Stromqualität einer Generatoranlage, insbesondere einer Netzgeneratoranlage sowie eine entsprechende Vorrichtung. Entsprechend wird ein Verfahren zum Überprüfen einer Stromqualität einer Generatoranlage vorgeschlagen, wobei ein Anschluss der Generatoranlage elektrisch leitfähig mit einem Anschluss eines Verbrauchers verbunden wird, wobei zwischen den Anschlüssen eine Impedanz vorgesehen ist und wobei anhand eines während des Betriebs der Generatoranlage gemessenen Impedanzwerts bestimmt wird, ob eine vorgegebene Leistung durch die Generatoranlage bereitgestellt wird.

Fig. 1

EP 4 589 310 A1

**Beschreibung**

Technisches Gebiet

Die vorliegende Erfindung betrifft ein Verfahren zum Überprüfen einer Stromqualität einer Generatoranlage, insbesondere einer Netzgeneratoranlage sowie eine entsprechende Vorrichtung.

Stand der Technik

Für Verbraucher wie ein Netz können zur entsprechenden Zertifizierung von Generatoranlagen Sicherheitsstandards vorgesehen sein, welche eine Kompatibilität der Generatoranlage mit dem Netz überprüfen beziehungsweise bestätigen. Um eine hinreichende Stromqualität bereitzustellen, müssen Generatoranlagen somit bei einer nicht vorhandenen Verbrauchergegenspannung beziehungsweise bei einer Gegenspannung gleich null balanciert sein. Mit anderen Worten müssen die Stromwerte von beispielsweise jeder der drei Phasen im Wesentlichen gleich sein, um zu verhindern, dass ein unbalancierter beziehungsweise unsymmetrischer Strom ins Netz eingespeist wird. Dies gilt selbst dann, wenn der Verbraucher selbst oder dessen Anschluss unsymmetrisch beziehungsweise unbalanciert ist.

Der Verbraucher kann dabei die am Anschluss der Generatoranlage gemessenen Stromwerte beeinflussen, sodass eine Überprüfung der Kompatibilität der Generatoranlage mit dem Verbraucher erschwert sein kann. Bei Generatoranlagen, welche als Synchronmaschine ausgebildet sind und den Strom direkt ins Netz und ohne anschlussseitigen Umrichter einspeisen, ist eine individuelle Anpassung der jeweiligen Phasen zudem nicht ohne weiteres möglich. Darüber hinaus gehen Anpassungen des Anschlusses der Generatoranlage zur Herstellung einer elektrisch leitfähigen Verbindung mit dem Verbraucher, um neuen Sicherheitsstandards zu entsprechen, mit erheblichen Kosten einher.

Entsprechend besteht ein Bedarf, eine sichere Überprüfung der Kompatibilität von Generatoranlagen mit einem Verbraucher für bestehende Anschlüsse bereitzustellen, welche insbesondere keine erhebliche Anpassung des Anschlusses erfordern.

Darstellung der Erfindung

Ausgehend von dem bekannten Stand der Technik ist es eine Aufgabe der vorliegenden Erfindung, ein verbessertes Verfahren zum Überprüfen der Stromqualität einer Generatoranlage sowie eine entsprechende Vorrichtung bereitzustellen.

Die Aufgabe wird durch ein Verfahren mit den Merkmalen des Anspruchs 1 gelöst. Vorteilhafte Weiterbildungen ergeben sich aus den Unteransprüchen, der Beschreibung und den Figuren.

Entsprechend wird ein Verfahren zum Überprüfen einer Stromqualität einer Generatoranlage vorgeschlagen, wobei ein Anschluss der Generatoranlage elektrisch leitfähig mit einem Anschluss eines Verbrauchers verbunden wird, wobei zwischen den Anschlüssen eine Impedanz vorgesehen ist und wobei anhand eines während des Betriebs der Generatoranlage gemessenen Impedanzwerts bestimmt wird, ob eine vorgegebene Leistung durch die Generatoranlage bereitgestellt wird.

Aufgrund der zusätzlich vorgesehenen Impedanz können lokale Einflüsse am Anschluss erheblich abgeschwächt werden, wodurch eine valide Überprüfung der Stromqualität der Generatoranlage bereitgestellt werden kann. Der tatsächliche Impedanzwert ist dabei gleichzeitig für die Leistung der Generatoranlage kennzeichnend, sodass die Überprüfung der Stromqualität vorteilhafterweise unter Berücksichtigung des Impedanzwerts erfolgen kann. Das Vorsehen der zusätzlichen Impedanz ist zudem verhältnismäßig günstig, sodass eine einfache und kosteneffiziente Lösung zur Kompatibilitätsprüfung der Generatoranlage bereitgestellt werden kann. Beispielsweise kann die Impedanz dabei in einem Prüfgerät zur Überprüfung eines sogenannten "*Fault-Ride-Through*", d. h. eine Überprüfung eines Durchfahrens der Generatoranlage beim Vorliegen von geringen Unterspannungen und/oder Fehlzuständen, implementiert sein.

Bevorzugt ist die vorgegebene Leistung kennzeichnend für das Vorliegen einer elektrischen Unsymmetrie oder Symmetrie ist. Insbesondere kann vorgesehen sein, dass anhand des gemessenen Impedanzwerts ein Verhältnis zwischen einem Gegensystemstromwert und einem Mitsystemstromwert der Generatoranlage bestimmt wird, wobei das Verhältnis kennzeichnend für die vorgegebene Leistung ist. So kann das Verhältnis insbesondere für das Vorliegen einer Unsymmetrie oder Symmetrie kennzeichnend sein, sodass anhand des Verhältnisses bestimmt werden kann, ob die Generatoranlage eine hinreichende Symmetrie des eingespeisten Stroms gewährleisten kann.

Vorliegend wurde erkannt, dass für die Generatoranlage der Mitsystemstromwert (1(Anlage)mit) und der Gegensystemstromwert ($I$(Anlage)$_{Geg}$) anhand der folgenden Gleichungen bestimmt werden können:

$$(1) \qquad I(Anlage)_{Mit} = \frac{(V(Anlage)_{Mit} - V(Verbraucher)_{Mit})}{Z(Verbraucher)_{Mit} + Z1_{Mit}}$$

$$(2) \qquad I(Anlage)_{Geg} = \frac{(V(Anlage)_{Geg} - V(Verbraucher)_{Geg})}{Z(Verbraucher)_{Geg} + Z1_{Geg}}$$

wobei die Spannung $V$ für die Generatoranlage und für den Verbraucher beziehungsweise ein Netz sowohl für das Mitsystem (Mit) und das Gegensystem (Geg) berücksichtigt werden. Weiterhin werden auch die Impedanz Z für den Verbraucher sowie die hinzugefügte mindestens eine symmetrische Impedanz Z1 für das Mitsystem und das Gegensystem berücksichtigt.

Daraus ergibt sich dann das Verhältnis wie folgt:

$$(3) \qquad Verhältnis = \left| \frac{I(Anlage)_{Geg}}{I(Anlage)_{Mit}} \right| \approx \left| \frac{-V(Verbraucher)_{Geg}}{Z1_{Geg} * I(Anlage)_{Mit}} \right| = \left| \frac{V(Verbraucher)_{Geg}}{Z1_{Mit} * I(Anlage)_{Mit}} \right|$$

Bevorzugt wird dabei eine vorgegebene Leistung bestimmt, wenn das Verhältnis unter einem vorgegebenen Schwellenwert liegt, wobei der Schwellenwert bevorzugt zwischen 1 Prozent und 10 Prozent liegt, besonders bevorzugt kleiner als 5 Prozent ist. Der Gegensystemstromwert ist somit bevorzugt erheblich kleiner als der Mitsystemstromwert, sodass das Verhältnis bei einer vorgegebenen Leistung einer hohen Stromqualität entspricht. Um eine besonders hohe Stromqualität und Kompatibilität mit dem Verbraucher zu gewährleisten, kann ein Schwellenwert kleiner als 5 Prozent gewählt sein, beispielsweise kleiner als 2 Prozent oder kleiner als 1,5 Prozent.

Aus Versuchen hat sich dabei herausgestellt, dass $V(Anlage)_{Geg}$ dabei einem Nullwert gleicht, wobei $V(Verbraucher)_{Geg}$ und $Z(Verbraucher)_{Geg}$ sich aufgrund der erheblich größeren Kurzschlussleistung des Verbrauchers im Vergleich zur Kurzschlussleistung der Generatoranlage als im Wesentlichen Konstanten erwiesen haben. Gleichermaßen kann angenommen werden, dass $I(Anlage)_{Mit}$ auch bei der hinzugefügten Impedanz im Wesentlichen konstant bleibt, zumal die Generatoranlage üblicherweise dazu eingerichtet ist, eine konstante Leistung zu erzeugen beziehungsweise bereitzustellen.

Entsprechend kann das Bestimmen einer vorliegenden vorgegebenen Leistung anhand eines Vergleichs des gemessenen Impedanzwerts mit einem vorgegebenen Schwellenwert erfolgen. Insbesondere kann das Bestimmen einer vorliegenden vorgegebenen Leistung dabei ausschließlich anhand eines Vergleichs des gemessenen Impedanzwerts mit einem vorgegebenen Schwellenwert erfolgt, bevorzugt anhand eines Impedanzwerts für den Mitsystemstromwert. Denn wie sich beispielsweise aus der vorstehenden Gleichung (3) für das Verhältnis sowie den entsprechenden Annahmen ergibt, kann das Verhältnis vorwiegend in Abhängigkeit vom Impedanzwert bestimmt werden, wobei das Verhältnis reduziert wird, wenn der Impedanzwert sich erhöht. So kann der Impedanzwert insbesondere von der Anlagenleistung oder Netzkurzschlussleistung abhängen, wobei der Schwellenwert beispielsweise im Bereich zwischen 1 Ohm und 60 Ohm oder höher liegen kann. Beispielsweise kann der Schwellenwert im Bereich zwischen 5 Ohm und 25 Ohm oder 10 Ohm und 20 Ohm liegen oder auch höher als 60 Ohm sein.

Entsprechend können vorteilhafterweise anhand von bekannten Werten für die Konstanten ein oder mehrere Schwellenwerte für den Impedanzwert festgelegt sein, welche einem jeweiligen Verhältnis entsprechen. Wird ein solcher Schwellenwert beispielsweise unterschritten, so deutet der Impedanzwert auf ein Verhältnis, das beispielsweise einer unzulässigen Unsymmetrie des bereitgestellten Stroms entspricht, sodass eine vorgegebene Leistung der Generatoranlage nicht bestimmt werden konnte. Umgekehrt kann ein Überschreiten des jeweiligen Schwellenwerts mit einer hinreichenden Symmetrie des bereitgestellten Stroms übereinstimmen, sodass die vorgegebene Leistung bestimmt werden konnte. Auf diese Weise kann somit anhand des Impedanzwerts auf eine Kompatibilität der Generatoranlage mit dem entsprechenden Verbraucher überprüft beziehungsweise festgestellt werden.

Bevorzugt wird ein Signal ausgegeben, ob eine vorgegebene Leistung durch die Generatoranlage bereitgestellt wird, wobei das Signal bevorzugt ein Schaltsignal für die Generatoranlage umfasst. Auf diese Weise kann das entsprechende Ergebnis beispielsweise an technisches Personal mitgeteilt werden, wobei das Ergebnis anhand des Signals ebenfalls gespeichert werden kann. Liegt keine vorgegebene Leistung vor und wird beispielsweise ein Strom mit einer unzulässigen Unsymmetrie erzeugt, so kann beispielsweise eine Fehlermeldung und/oder ein Warnsignal ausgegeben werden. Optional kann die Generatoranlage anhand eines Schaltsignals ebenfalls vollständig vom Verbraucher getrennt werden. Gleichermaßen kann auch ein Signal ausgegeben werden, welches die Kompatibilität der Generatoranlage bestätigt, wobei optional ein Schaltsignal ausgegeben werden kann, um die Generatoranlage im zugeschalteten Zustand mit dem Verbraucher zu behalten oder diese darin zu versetzen.

Obwohl verschiedene Verbraucher mit der Generatoranlage verbunden werden können, beispielsweise auch industrielle Verbraucher oder lokale Anlagen, ist der Verbraucher bevorzugt ein Netz. Das Netz kann dabei ebenfalls einen unsymmetrischen Anschluss umfassen beziehungsweise Unsymmetrien in der abgefragten Last aufweisen, beispielsweise aufgrund von Verbraucherschwankungen oder Unregelmäßigkeiten im Netz. Die vorliegende Erfindung ermöglicht dabei vorteilhafterweise dennoch, dass die Generatoranlage selbst im verbundenen Zustand mit dem Netz valide hinsichtlich der bereitgestellten Stromqualität überprüft werden kann.

Die Generatoranlage kann weiterhin einen Dreiphasenstrom bereitstellen. Insbesondere kann die Generatoranlage eine Synchronmaschine frei von einem anschlussseitigen Umrichter sein. Anders als bei beispielsweise Windturbinen oder Photovoltaikanlagen kann der erzeugte Strom somit bevorzugt direkt und ohne Anpassung der jeweiligen Phasen in ein Netz eingespeist werden. In dieser Ausgestaltung beziehen sich ein Mitsystem und Gegensystem entsprechend auf die entsprechenden Leiterströme beziehungsweise die entsprechenden Phasoren.

Die vorgesehene jeweilige Impedanz oder jeweilige mehrere Impedanzen und/oder die Phasoren ist/sind dabei bevorzugt für jede Phase gleich und es kann für jede einzelne Phase bestimmt werden, ob eine vorgegebene Leistung durch die Generatoranlage bereitgestellt wird. Bevorzugt wird anhand des jeweiligen Ergebnisses ein phasenspezifisches Signal ausgegeben. Obwohl das Verfahren keine unmittelbare Anpassung der Phasen vorsieht, kann auf diese Weise dennoch nachgewiesen werden, ob für eine oder mehrere Phasen ein bestimmtes Problem vorliegt, sodass eine Fehlerbeseitigung erleichtert werden kann.

Um das Verfahren zu steuern und zu erleichtern, können weiterhin ein oder mehrere zusätzliche Schalter vorgesehen sein, bevorzugt in Form von Leistungsschaltern. Auf diese Weise lassen sich beispielsweise eine Herstellung einer elektrisch leitfähigen Verbindung zwischen der Generatoranlage und dem Verbraucher erleichtern und/oder eine selektive Ausführung des Verfahrens ermöglichen. Entsprechend ist bevorzugt vorgesehen, dass vor und/oder nach der Impedanzmessung eine direkte elektrisch leitfähige Verbindung zwischen dem Anschluss der Generatoranlage und dem Anschluss des Verbrauchers mittels eines parallel zur Impedanz vorgesehenen Schalters bereitgestellt wird. Ein solcher Schalter beziehungsweise Leistungsschalter ermöglicht somit, dass die Impedanz umgangen werden kann und der erzeugte Strom quasi direkt an den Verbraucher weitergeleitet wird. Beispielsweise kann der Schalter anhand eines ausgegebenen Signals betätigt oder geschaltet werden, wenn festgestellt wird, dass eine vorgegebene Leistung der Generatoranlage vorliegt. Umgekehrt kann eine direkte Verbindung anhand des Schalters vermieden werden, wenn beispielsweise ein gemessener Impedanzwert zu niedrig ist und einen vorgegebenen Schwellenwert nicht überschreitet.

Alternativ oder zusätzlich kann ebenfalls vorgesehen sein, dass vor und/oder nach der Impedanzmessung keine elektrisch leitfähige Verbindung zwischen dem Anschluss der Generatoranlage und dem Anschluss des Verbrauchers mittels eines zwischen der Impedanz und dem Anschluss des Verbrauchers vorgesehenen Schalters bereitgestellt wird. Mit anderen Worten kann vor der Impedanz in Reihe ein Schalter wie ein Leistungsschalter vorgesehen sein, welche nur dann geschaltet wird, wenn das Verfahren ausgeführt werden soll. So können beispielsweise sowohl ein paralleler Leistungsschalter und ein in Reihe angeordnete Leistungsschalter zunächst geöffnet sein, wonach der in Reihe angeordnete Leistungsschalter geschlossen wird, um das Verfahren auszuführen.

Wird dabei festgestellt, dass eine vorgegebene Leistung der Generatoranlage vorliegt, so kann der parallele Leistungsschalter geschaltet werden, um beispielsweise eine direkte Einspeisung in ein Netz zu ermöglichen. Wird jedoch keine vorgegebene Leistung der Generatoranlage festgestellt, so können sowohl der in Reihe angeordnete Leistungsschalter als auch der parallel angeordnete Leistungsschalter geöffnet werden, um die Generatoranlage zunächst vollständig vom Netz zu trennen. Das Vorsehen der beiden Leistungsschalter, d. h. der in Reihe angeordnete Leistungsschalter und der parallele Leistungsschalter hat neben dieser Möglichkeit einer selektiven Schaltung zudem den Vorteil, dass dadurch der Anschluss zwischen dem Verbraucher und der Generatoranlage erleichtert werden kann.

Die oben gestellte Aufgabe wird weiterhin durch eine Vorrichtung zum Überprüfen einer Stromqualität einer Generatoranlage mit den Merkmalen des Anspruchs 13 gelöst. Vorteilhafte Weiterbildungen des Verfahrens ergeben sich aus den Unteransprüchen sowie der vorliegenden Beschreibung und den Figuren.

Entsprechend wird eine Vorrichtung zum Überprüfen einer Stromqualität einer Generatoranlage vorgeschlagen, umfassend eine Schnittstelle zum elektrisch leitfähigen Anschließen der Vorrichtung an einem Anschluss der Generatoranlage und eine Schnittstelle zum elektrisch leitfähigen Anschließen der Vorrichtung an einem Verbraucher, sowie mindestens eine Impedanz, welche zwischen den Schnittstellen derart angeordnet ist, dass ein Strom im angeschlossenen Zustand der Schnittstellen und im Betrieb der Generatoranlage von der Generatoranlage zum Verbraucher über die mindestens eine Impedanz geführt wird. Weiterhin ist eine Auswerteeinheit vorgesehen, welche mit der mindestens einen Impedanz verbunden und dazu eingerichtet ist, anhand eines gemessenen Impedanzwerts zu bestimmen, ob eine vorgegebene Leistung durch die Generatoranlage bereitgestellt wird und anhand des bestimmten Ergebnis ein Signal auszugeben.

Der Impedanzwert kann dabei optional durch eine mit der Auswerteeinheit gekoppelten oder darin integrierten Impedanzmessvorrichtung erfasst beziehungsweise gemessen werden.

Die Vorrichtung kann dabei bevorzugt in einem Prüfgerät zur Überprüfung eines sogenannten "*Fault-Ride-Through*", d. h. eine Überprüfung eines Durchfahrens der Generatoranlage beim Vorliegen von geringen Unterspannungen und/oder Fehlzuständen, implementiert sein. Weiterhin können mehrere Impedanzen in Reihe vorgesehen sein, um gemeinsam eine Impedanz zu bilden und/oder es können auch individuelle Impedanzen beispielsweise für jede Phase der Generatoranlage, welche dazu eingerichtet ist, einen Dreiphasenstrom bereitzustellen, vorgesehen sein, wobei die Impedanzen bevorzugt gleich sind.

Bevorzugt ist die Vorrichtung dazu eingerichtet, das vorstehend beschriebene, erfindungsgemäße Verfahren auszuführen, sodass Aspekte, Merkmale und Vorteile, die im Hinblick auf das Verfahren beschrieben wurden ebenfalls für die Vorrichtung gelten und auf eine wiederholte Beschreibung lediglich aus Redundanzgründen verzichtet wird.

Wie vorstehend im Hinblick auf das Verfahren erläutert, kann die Vorrichtung ebenfalls einen oder mehrere Schalter beziehungsweise Leistungsschalter umfassen. Entsprechend kann ein Schalter vorgesehen sein, welcher parallel zur mindestens einen Impedanz angeordnet und dazu eingerichtet ist, eine direkte elektrisch leitfähige Verbindung zwischen dem Anschluss der Generatoranlage und dem Anschluss des Verbrauchers bereitzustellen. Alternativ oder zusätzlich kann auch ein Schalter vorgesehen sein, welcher zwischen der verbraucherseitigen Schnittstelle und der Impedanz beziehungsweise in Reihe mit der Impedanz angeordnet ist. Auf diese Weise lassen sich beispielsweise eine Herstellung einer elektrisch leitfähigen Verbindung zwischen der Generatoranlage und dem Verbraucher erleichtern und/oder eine selektive Ausführung des Verfahrens ermöglichen. Ebenfalls können hierdurch eine Trennung der Generatoranlage vom Verbraucher beziehungsweise vom Netz oder auch eine direkte Einspeisung des erzeugten Stroms ins Netz ermöglicht oder zumindest vereinfacht werden.

Kurze Beschreibung der Figuren

Bevorzugte weitere Ausführungsformen der Erfindung werden durch die nachfolgende Beschreibung der Figur näher erläutert. Dabei zeigt:

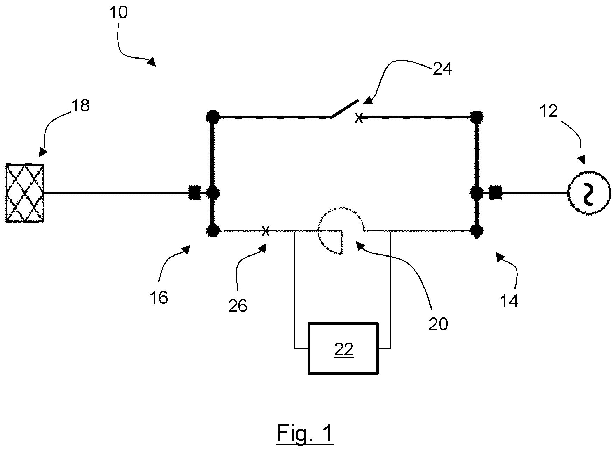

Figur 1 eine schematische Darstellung einer Vorrichtung gemäß der Erfindung zum Ausführen des erfindungsgemäßen Verfahrens in einer bevorzugten Ausführungsform.

Detaillierte Beschreibung bevorzugter Ausführungsbeispiele

Im Folgenden werden bevorzugte Ausführungsbeispiele anhand der Figur beschrieben.

In Figur 1 ist schematisch eine Vorrichtung 10 zum Überprüfen einer Stromqualität einer Generatoranlage 12 gezeigt. Um eine elektrisch leitfähige Verbindung zwischen der Vorrichtung 10 und der Generatoranlage 12 bereitzustellen, ist eine Schnittstelle 14 vorgesehen, welche mit einem Anschluss oder Terminal der Generatoranlage 12 verbunden werden kann. Entsprechend ist ebenfalls eine Schnittstelle 16 vorgesehen, um eine elektrisch leitfähige Verbindung zum Anschluss eines Verbrauchers 18 bereitzustellen. Im vorliegenden Beispiel handelt es sich bei der Generatoranlage 12 um eine Synchronmaschine, welche dazu eingerichtet ist, einen Dreiphasenstrom bereitzustellen, wobei es sich beim Verbraucher 18 um ein Netz handelt.

Um zu überprüfen, ob die Generatoranlage 12 eine hinreichende Stromqualität bereitstellt, ist zwischen den Schnittstellen 14, 16 eine Impedanz 20 vorgesehen. Wie vorstehend erläutert, kann anhand der Impedanz 20 besonders vorteilhaft nachgewiesen werden, ob ein vorgegebenes Verhältnis zwischen dem Gegensystemstromwert und dem Mitsystemstromwert vorliegt, wodurch beispielsweise unzulässige Unsymmetrien seitens der Generatoranlage 12 ausgeschlossen werden können. So kann beispielsweise ein Schwellenwert für die Impedanz 20 festgelegt sein, welcher einem vorgegebenen Verhältnis entspricht und im Falle einer vorgegebenen Leistung beziehungsweise einer hinreichenden Stromqualität überschritten werden soll. Um diesen Vergleich zu ermöglichen, ist eine Auswerteeinheit 22 vorgesehen, welche die gemessene Impedanzwerte erhält und vorteilhafterweise dazu ausgelegt sein kann, den gemessenen Impedanzwert mit einem festgelegten Schwellenwert zu vergleichen und ein dem Ergebnis entsprechendes Signal auszugeben.

Um die Impedanzmessung selektiv vorzunehmen, sind weiterhin zwei Schalter 24, 26 vorgesehen, welche als Leistungsschalter ausgebildet sind. Schalter 24 ist dabei parallel zur Impedanz 20 angeordnet und ermöglicht somit eine direkte elektrisch leitfähige Verbindung zwischen den Schnittstellen 14, 16 beziehungsweise zwischen der Generatoranlage 12 und dem Verbraucher 18. Ebenfalls kann eine solche direkte Verbindung aufgrund des Schalters 24 getrennt werden, wenn die Generatoranlage 12 beispielsweise vom Verbraucher 18 getrennt werden soll.

Der Schalter 26 ist in Reihe mit der Impedanz 20 und zwischen der Impedanz 20 und der Schnittstelle 16 angeordnet. Durch Betätigung des Schalters 26 kann die Überprüfung der Stromqualität selektiv erfolgen, indem der von der Generatoranlage 12 erzeugte Strom nur bei geöffnetem Schalter 24 und bei geschlossenem Schalter 26 über die Impedanz 20 geführt wird. Die Auswerteeinheit 22 ermittelt in diesem Fall den entsprechenden Impedanzwert, welcher für die Leistung und Stromqualität der Generatoranlage 12 kennzeichnend ist.

Obwohl nicht gezeigt in der schematischen Darstellung gemäß Figur 1, können weitere Komponenten zwischen der Generatoranlage 12 und dem Verbraucher 18 vorgesehen sein. Insbesondere können ein oder mehrere Transformatoren auf der Seite der Generatoranlage 12 vorgesehen sein, welche über entsprechende Anschlüsse oder Terminals, bevorzugt in Reihe, zugeschaltet sind. Weiterhin sind die Schalter 24, 26 optional und können beispielsweise in Abhängigkeit der erforderlichen Konfiguration vorgesehen sein.

Soweit anwendbar, können alle einzelnen Merkmale, die in den Ausführungsbeispielen dargestellt sind, miteinander kombiniert und/oder ausgetauscht werden, ohne den Bereich der Erfindung zu verlassen.

Bezugszeichenliste

10 Vorrichtung
12 Generatoranlage
14 Schnittstelle
16 Schnittstelle
18 Verbraucher
20 Impedanz
22 Auswerteeinheit
24 Schalter
26 Schalter

**Patentansprüche**

1. Verfahren zum Überprüfen einer Stromqualität einer Generatoranlage, wobei ein Anschluss der Generatoranlage elektrisch leitfähig mit einem Anschluss eines Verbrauchers verbunden wird, wobei zwischen den Anschlüssen eine Impedanz vorgesehen ist und wobei anhand eines während des Betriebs der Generatoranlage gemessenen Impedanzwerts bestimmt wird, ob eine vorgegebene Leistung durch die Generatoranlage bereitgestellt wird.

2. Verfahren gemäß Anspruch 1, wobei die vorgegebene Leistung kennzeichnend für das Vorliegen einer elektrischen Unsymmetrie oder Symmetrie ist.

3. Verfahren gemäß Anspruch 1 oder 2, wobei anhand des gemessenen Impedanzwerts ein Verhältnis zwischen einem Gegensystemstromwert und einem Mitsystemstromwert der Generatoranlage bestimmt wird, wobei das Verhältnis kennzeichnend für die vorgegebene Leistung ist.

4. Verfahren gemäß Anspruch 3, wobei eine vorgegebene Leistung bestimmt wird, wenn das Verhältnis unter einem vorgegebenen Schwellenwert liegt, wobei der Schwellenwert bevorzugt zwischen 1 Prozent und 10 Prozent liegt, besonders bevorzugt kleiner als 5 Prozent ist.

5. Verfahren gemäß einem der vorstehenden Ansprüche, wobei das Bestimmen einer vorliegenden vorgegebenen Leistung anhand eines Vergleichs des gemessenen Impedanzwerts mit einem vorgegebenen Schwellenwert erfolgt.

6. Verfahren gemäß Anspruch 5, wobei das Bestimmen einer vorliegenden vorgegebenen Leistung ausschließlich anhand eines Vergleichs des gemessenen Impedanzwerts mit einem vorgegebenen Schwellenwert erfolgt, bevorzugt anhand eines Impedanzwerts für den Mitsystemstromwert.

7. Verfahren gemäß einem der vorstehenden Ansprüche, wobei ein Signal ausgegeben wird, ob eine vorgegebene Leistung durch die Generatoranlage bereitgestellt wird, wobei das Signal bevorzugt ein Schaltsignal für die Generatoranlage umfasst.

8. Verfahren gemäß einem der vorstehenden Ansprüche, wobei die Generatoranlage einen Dreiphasenstrom bereitstellt.

9. Verfahren gemäß Anspruch 8, wobei die Generatoranlage eine Synchronmaschine frei von einem anschlussseitigen Umrichter ist.

10. Verfahren gemäß Anspruch 8 oder 9, wobei für jede Phase die gleiche Impedanz vorgesehen ist und für jede einzelne Phase bestimmt wird, ob eine vorgegebene Leistung durch die Generatoranlage bereitgestellt wird, wobei bevorzugt anhand des jeweiligen Ergebnisses ein phasenspezifisches Signal ausgegeben wird.

11. Verfahren gemäß einem der vorstehenden Ansprüche, wobei der Verbraucher ein Netz ist, bevorzugt mit einem unsymmetrischen Anschluss.

12. Verfahren gemäß einem der vorstehenden Ansprüche, wobei vor und/oder nach der Impedanzmessung

- eine direkte elektrisch leitfähige Verbindung zwischen dem Anschluss der Generatoranlage und dem Anschluss des Verbrauchers mittels eines parallel zur Impedanz vorgesehenen Schalters bereitgestellt wird; und/oder
- keine elektrisch leitfähige Verbindung zwischen dem Anschluss der Generatoranlage und dem Anschluss des Verbrauchers mittels eines zwischen der Impedanz und dem Anschluss des Verbrauchers vorgesehenen Schalters bereitgestellt wird.

13. Vorrichtung (10) zum Überprüfen einer Stromqualität einer Generatoranlage (12), umfassend

eine Schnittstelle (14) zum elektrisch leitfähigen Anschließen der Vorrichtung (10) an einem Anschluss der Generatoranlage (12) und eine Schnittstelle (16) zum elektrisch leitfähigen Anschließen der Vorrichtung (10) an einem Verbraucher (18),
mindestens eine Impedanz (20), welche zwischen den Schnittstellen (14, 16) derart angeordnet ist, dass ein Strom im angeschlossenen Zustand der Schnittstellen (14, 16) und im Betrieb der Generatoranlage (12) von der Generatoranlage (12) zum Verbraucher (18) über die mindestens eine Impedanz (20) geführt wird, und
eine Auswerteeinheit (22), welche mit der mindestens einen Impedanz (20) verbunden und dazu eingerichtet ist, anhand eines gemessenen Impedanzwerts zu bestimmen, ob eine vorgegebene Leistung durch die Generatoranlage (12) bereitgestellt wird und anhand des bestimmten Ergebnis ein Signal auszugeben.

14. Vorrichtung (10) gemäß Anspruch 13, welche dazu eingerichtet ist, das Verfahren gemäß einem der Ansprüche 1 bis 12 auszuführen.

15. Vorrichtung (10) gemäß Anspruch 13 oder 14, umfassend

- einen Schalter (24), welcher parallel zur mindestens einen Impedanz (20) angeordnet und dazu eingerichtet ist, eine direkte elektrisch leitfähige Verbindung zwischen dem Anschluss der Generatoranlage (12) und dem Anschluss des Verbrauchers (18) bereitzustellen; und/oder
- einen Schalter (26), welcher zwischen der verbraucherseitigen Schnittstelle (16) und der Impedanz (20) angeordnet ist.

Fig. 1

EP 4 589 310 A1

Europäisches
Patentamt
European
Patent Office
Office européen
des brevets

# EUROPÄISCHER RECHERCHENBERICHT

Nummer der Anmeldung

EP 25 15 2558

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 2014/117912 A1 (GAJIC ZORAN [SE] ET AL) 1. Mai 2014 (2014-05-01)<br>* Abbildung 1 *<br>* Absatz [0009] - Absatz [0012] *<br>* Absatz [0032] - Absatz [0033] *<br>* Absatz [0044] - Absatz [0045] *<br>* Absatz [0050] - Absatz [0055] *<br>----- | 1-15 | INV.<br>G01R27/16<br>G01R31/34<br>G01R27/02<br>G01R31/42<br>H02J3/26<br>H02K19/36 |
| A | WO 2014/117279 A1 (UNIV SASKATCHEWAN [CA]) 7. August 2014 (2014-08-07)<br>* Abbildung 1 *<br>* Absatz [0036] - Absatz [0117] *<br>----- | 1-15 | |
| A | US 2017/373625 A1 (ANDERSEN SØREN [DK] ET AL) 28. Dezember 2017 (2017-12-28)<br>* Abbildungen 2,3 *<br>* Absatz [0037] *<br>* Absatz [0053] - Absatz [0071] *<br>----- | 1-15 | |

RECHERCHIERTE SACHGEBIETE (IPC)

G01R
H02K
H02J

Der vorliegende Recherchenbericht wurde für alle Patentansprüche erstellt

| Recherchenort | Abschlußdatum der Recherche | Prüfer |
|---|---|---|
| München | 5. Juni 2025 | Kleiber, Michael |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)

## ANHANG ZUM EUROPÄISCHEN RECHERCHENBERICHT
## ÜBER DIE EUROPÄISCHE PATENTANMELDUNG NR.

EP 25 15 2558

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

05-06-2025

| Im Recherchenbericht angeführtes Patentdokument | Datum der Veröffentlichung | Mitglied(er) der Patentfamilie | | Datum der Veröffentlichung |
|---|---|---|---|---|
| US 2014117912 A1 | 01-05-2014 | CN | 103782509 A | 07-05-2014 |
| | | EP | 2730023 A1 | 14-05-2014 |
| | | RU | 2014103627 A | 10-08-2015 |
| | | US | 2014117912 A1 | 01-05-2014 |
| | | WO | 2013004285 A1 | 10-01-2013 |
| WO 2014117279 A1 | 07-08-2014 | KEINE | | |
| US 2017373625 A1 | 28-12-2017 | CN | 107250820 A | 13-10-2017 |
| | | EP | 3245528 A1 | 22-11-2017 |
| | | ES | 2850283 T3 | 26-08-2021 |
| | | US | 2017373625 A1 | 28-12-2017 |
| | | WO | 2016112915 A1 | 21-07-2016 |

EPO FORM P0461

Für nähere Einzelheiten zu diesem Anhang : siehe Amtsblatt des Europäischen Patentamts, Nr.12/82